(19) Europäisches Patentamt
European Patent Office
Office européen des brevets

(11) **EP 3 722 451 A1**

(12) **EUROPÄISCHE PATENTANMELDUNG**

(43) Veröffentlichungstag:
**14.10.2020 Patentblatt 2020/42**

(51) Int Cl.:
***C23C 14/04*** *(2006.01)*   ***C23C 14/50*** *(2006.01)*
***C23C 14/54*** *(2006.01)*

(21) Anmeldenummer: **19168047.9**

(22) Anmeldetag: **09.04.2019**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **FRAUNHOFER-GESELLSCHAFT zur
Förderung
der angewandten Forschung e.V.
80686 München (DE)**

(72) Erfinder:
• **Vergöhl, Michael
  38108 Braunschweig (DE)**
• **Pfug, Andreas
  38108 Braunschweig (DE)**
• **Bruns, Stefan
  38108 Braunschweig (DE)**
• **André, Kaiser
  38108 Braunschweig (DE)**
• **Melzig, Thomas
  38108 Braunschweig (DE)**
• **Zickenrott, Tobias
  38108 Braunschweig (DE)**

(74) Vertreter: **Pfenning, Meinig & Partner mbB
Patent- und Rechtsanwälte
Theresienhöhe 11a
80339 München (DE)**

(54) **VORRICHTUNG UND VERFAHREN ZUR BESCHICHTUNG VON SUBSTRATEN MIT PLANAREN ODER GEFORMTEN OBERFLÄCHEN MITTELS MAGNETRON-SPUTTERN**

(57) Erfindungsgemäß wird eine Vorrichtung zur Beschichtung von Substraten mit planaren oder geformten Oberflächen mittels Magnetron-Sputtern bereitgestellt, mit der beliebig geformte Oberflächen, zum Beispiel Linsen, Asphären oder Freiformflächen mit einem einstellbaren Schichtdickenprofil beschichtet werden können, so dass eine Schichtfunktion auf der im wesentlichen ganzen Fläche erhalten bleibt. Ebenso wird ein solches Verfahren bereitgestellt.

EP 3 722 451 A1

**Beschreibung**

Erfindungsgemäß wird eine Vorrichtung zur Beschichtung von Substraten mit planaren oder geformten Oberflächen mittels Magnetron-Sputtern bereitgestellt, mit der beliebig geformte Oberflächen, zum Beispiel Linsen, Asphären oder Freiformflächen mit einem einstellbaren Schichtdickenprofil beschichtet werden können, so dass eine Schichtfunktion auf der im wesentlichen ganzen Fläche erhalten bleibt. Ebenso wird ein solches Verfahren bereitgestellt.

In optischen Systemen sind gekrümmte Oberflächen weit verbreitet. Eingesetzt werden Linsen, asphärische Komponenten oder auch Freiformflächen, um Licht zu lenken, oder Abbildungen des Lichtes durchzuführen. Diese verschiedenen Formen werden im Folgenden als "optische Komponenten" bezeichnet. Abbildungsfehler spielen dabei eine große Rolle.

In der Regel werden die optischen Komponenten mit einer Beschichtung versehen. Die Beschichtung kann unterschiedliche Funktionen haben. In einigen Fällen kann, um das optische System kompakt zu gestalten, ein Bandpassfilter oder ein Kantenfilter auf die optische Komponente aufgebracht sein. Dabei kann auch eine gekrümmte Oberfläche beschichtet werden.

Die Beschichtung ist oftmals auch eine Entspiegelung, die entweder bei einer bestimmten Wellenlänge oder über einen breiten Spektralbereich wirken kann. Das Substratmaterial ist in der Regel Glas oder Kunststoff.

Die optischen Komponenten können hergestellt werden durch Pressen, oder auch durch mechanische Bearbeitung. Je nach Material, d.h. Brechungsindex der optischen Komponenten reflektiert das Substratmaterial einige % des Lichtes.

Die Reflexion gegen Luft wird nach der Formel (I)

$$R = (n-1)\text{^2} / (n+1)\text{^2} \qquad (I)$$

berechnet, wobei n der Brechungsindex der optischen Komponente ist.

Optische Komponenten können auch in Medien wie Öle oder Kitt eingebaut sein, wobei dann in der Formel (I) der Brechungsindex 1 für Luft durch den Brechungsindex des Mediums der Umgebung verwendet werden muss.

Oftmals werden auch mehrere optische Komponenten als Kit bereitgestellt. Über die Auswahl des Kits kann so die Reflexion zwischen den Komponenten reduziert werden.

Bei einer Entspiegelung müssen in der Regel beide Seiten der optischen Komponenten beschichtet werden, wobei ein mehr oder weniger breiter Spektralbereich vorgesehen wird. Bei einer einfachen Breitbandentspiegelung wird oftmals der Bereich 420-680 nm entspiegelt, wobei eine Reflexion von weniger als 0.5% über diesen Bereich notwendig ist. Wenn es sich um ein flaches Substrat handelt, genügt hierfür eine Beschichtung der Form:

Glas -$TiO_2$ (10nm) - $SiO_2$ (40nm) -$TiO_2$ (110nm) - $SiO_2$ (85nm)

$SiO_2$ ist ein niederbrechendes Material, welches als Schicht üblicherweise typisch einen Brechungsindex von ca. 1.48 (bei einer Wellenlänge von 550nm) aufweist. $TiO_2$ ist ein hochbrechendes Material mit einem Brechungsindex von 2.4 bis 2.7. Neben $SiO_2$ und $TiO_2$ können eine Vielzahl anderer Materialien ebenso eingesetzt werden. Als niederbrechende Schichten eignen sich auch $Al_2O_3$, als hochbrechende $Ta_2O_5$, $Nb_2O_5$, $HfO_2$, $ZrO_2$, $Sc_2O_3$, $Al_2O_3$ oder Mischungen davon.

Oftmals ist der vorgesehene Spektralbereich deutlich größer und auch die Restreflexion ist niedriger spezifiziert. Dies ist besonders wichtig bei optischen Systemen mit einer Vielzahl von optischen Komponenten. Dort sind nicht nur die Lichtverluste wichtig, sondern vielmehr auch Geisterbilder durch mehrfach im System reflektiertes Licht. Diese kommen dadurch zustande, dass an den einzelnen Oberflächen restliches Licht reflektiert werden kann. Dieses geht dann teilweise den Strahlengang zurück, hat aber nicht mehr die gewünschte Abbildungseigenschaft. Über mehrere Reflexionen kann dieses Licht dann als störendes bzw. Streulicht in den Detektor gelangen. Streulicht kann den Kontrast reduzieren oder es können Geisterbilder entstehen. Mit größerem Spektralbereich und geringerer Restreflexion muss die Schichtzahl und damit die Gesamtschichtdicke in der Regel erhöht werden.

Neben reflexionsmindernden Schichten können auch diverse Filter eingesetzt werden.

Ein solcher Filter besteht im Allgemeinen ebenfalls aus einer Abfolge von abwechselnd hoch- und niederbrechenden Schichten mit Schichtdicken. Je nach Anwendung können die einzelnen Schichtdicken zwischen 1 und mehreren 100nm betragen. Bei Filtern beträgt die Gesamtzahl der Schichten meist mehr als 10 und kann auch viele Hundert erreichen. Damit ergeben sich im sichtbaren Spektralbereich Gesamtschichtdicken von etwa 1000 nm bis über 30000 nm. Im Infrarotbereich können die Schichtdicken sogar 100000 nm erreichen oder sogar überschreiten.

Die Verwendung eines Filters direkt auf der gekrümmten Komponente hat den Vorteil, dass das optische System deutlich kompakter gebaut werden kann. Auf die Verwendung eines Planfilters kann somit verzichtet werden, wenn ein Filter direkt auf die Linsenoberfläche aufgebracht werden kann. Derartige Filter können ein Bandpassfilter sein. Dieser lässt einen engen und genau definierten Spektralbereich durch und blockiert den restlichen Spektralbereich. Einsetzbar ist ein solcher Bandpassfilter beispielsweise in einem LIDAR-System. Dort wird das vom Laser ausgesandte Licht als Streulicht der Umgebung gemessen. Das LIDAR-Signal ist wesentlich schwächer als das Licht der Umgebung, so dass eine Unterdrückung des Umgebungslichtes erfolgen muss. Ein LIDAR Filter für einen 532nm Laser würde daher auf einer Linse einen Bandpass von 10nm Halbwertsbreite haben und eine Blockung mit OD 6 zwischen 200nm bis 1100nm. Wenn der Filter direkt auf der optischen Komponente aufgebracht wird, hat das den Vorteil, dass das Umgebungslicht immer senkrecht auf den Filter auftrifft. Bei einem Plansubstrat müsste dagegen eine Zwischenabbildung vorgenommen werden, damit das Licht immer senkrecht auf den Filter auftrifft.

Bei optischen Komponenten tritt oft der weitere Fall auf, dass das Licht über die gesamte Linsenoberfläche parallel auftrifft. Wenn es sich um eine konvexe, konkave oder um eine Freiformoberfläche handelt, ist der Einfallswinkel des Lichtes auf die Oberfläche nicht konstant, sondern abhängig vom Ort, wo das Licht auftrifft. Im Zentrum ist der Lichteinfall senkrecht, am Rand der Linse ist der Einfallswinkel größer und abhängig von der Form der optischen Komponente. Teilweise gibt es auch Anwendungen, bei denen Lichtstrahlen mehrmals ein und dieselbe Optik unter unterschiedlichem Öffnungswinkel durchlaufen. Hierbei werden beispielsweise unterschiedliche Bereiche der Linse ausgenutzt.

Bei Freiformflächen besteht zudem keine Rotationssymmetrie, d.h. die Krümmung ist abhängig von der Winkelposition des optischen Elements.

Der Effekt des unterschiedlichen Einfallswinkels des Lichts auf die Oberfläche führt dazu, dass das Spektrum sich zu kürzeren Wellenlängen verschiebt. Auch die Form des Spektrums selber kann sich verändern.

Es kann daher günstig sein, die Beschichtung derart aufzubringen, dass diese am Rand der optischen Komponente dicker ist als in der Mitte, so dass der Effekt der Winkelverschiebung kompensiert wird. Trifft das Licht senkrecht von oben auf die Linse, so erfolgt eine spektrale Korrektur, so dass keine spektrale Verschiebung der Spektren oder eine Änderung der Intensitäten bei Transmission oder bei Reflexion auftritt. Das transmittierte oder reflektierte Spektrum ist gleich unabhängig vom Ort, wo das Licht auftrifft.

Bei einer Anwendung, wo verschiedene Bereiche der Linse von unterschiedlichen Lichtstrahlen mit unterschiedlichem Öffnungswinkel durchlaufen werden, könnte die Variation der Schichtdicke auch unterschiedlich ausgeführt werden.

Die Beschichtung von optischen Komponenten kann mit chemischen Verfahren erfolgen. Hierbei kann beispielsweise das Verfahren der Atomlagenabscheidung (engl. atomic layer deposition, ALD) eingesetzt werden. Nachteil der ALD ist allerdings, dass es kaum eine Möglichkeit gibt, die Beschichtung auf dem Bauteil gezielt zu verändern. Vielmehr resultiert im Idealfall eine homogene gleichförmige Beschichtung auch auf 3D Bauteilen. Der Effekt der Winkelverschiebung bei parallel einfallendem Licht kann mit einem solchen Verfahren daher nicht kompensiert werden.

Weiterhin werden häufig Verfahren der physikalischen Gasphasenabscheidung (engl. physical vapor deposition, PVD) eingesetzt, insbesondere Aufdampfverfahren oder Sputterverfahren. Bei den PVD-Verfahren gibt es entweder keine chemische Reaktion der schichtbildenden Teilchen oder im Falle reaktiver PVD-Verfahren erfolgt die Reaktion ausschließlich an den Reaktor- bzw. Substratflächen. Die Abscheidung erfolgt durch Verdampfen aus einem Tiegel im Hochvakuum oder durch Sputtern von einem Target bei typischem Arbeitsdrücken von 0.05 bis 3.0 Pa, bevorzugt von 0.1 bis 1 Pa.

Beim Magnetron-Sputtern erfolgt bevorzugt eine relativ schnelle Drehtellerrotation. Die Substrate sind dabei am Drehteller angebracht und werden somit rotatorisch und periodisch durch Beschichtungsreaktoren mit statisch positionierten Sputterquellen bewegt. Mit jedem Durchlauf wird jeweils eine dünne Teilschicht eines Metalls oder einer Metallverbindung aufgetragen. In einer zusätzlichen, optionalen Plasmakammer kann die Stöchiometrie der Metallverbindung angepasst werden.

Die Magnetronsputter-Quellen können planar oder auch zylindrisch geformt sein. Zudem können sie als Einzel- oder als Doppel-Magnetronsystem ausgelegt werden.

Bei einer rotatorischen Substrat-Anordnung mit linearen Beschichtungs-Quellen ist das sich auf dem Substrat ergebende Schichtprofil nicht homogen. Bei einem flachen Substrat nimmt die Rate mit der Abhängigkeit gemäß 1/r nach außen hin ab, wobei r dem Abstand zwischen dem Drehtellermittelpunkt und des betrachteten Punktes des Substrats entspricht.

Ist das Substrat gekrümmt, so ergeben sich zusätzliche Schichtdickenvariationen aufgrund der unterschiedlichen Abstände zwischen Sputterquelle und Substrat und unterschiedlicher Neigungswinkel der Substratfläche in Bezug auf die Beschichtungsrichtung.

Ein üblicher Ansatz zur Kompensation der Schichtdickenverteilung auf der Linse und dem Winkelshift besteht darin, über ein besonderes Design diese Effekte aufzufangen. Allerdings wird hierbei das Schichtdesign sehr aufwändig und kann aus sehr vielen Schichten bestehen.

Bei Beschichtungsvorrichtungen mit langsam rotierendem Teller bzw. Trommel (d.h. der Drehteller dreht sich mit Frequenzen von weniger als 50 rpm) wird oftmals eine schnelle Planetenrotation der optischen Komponenten vorgesehen. Als Faustregel sollte die Eigenrotation der Komponenten mindestens 10mal so schnell wie die Rotation des Tellers bzw. der Trommel sein. Bei einer schnellen Rotation des Substrates kann das Schichtprofil somit ausgeglichen werden.

In US 6,250,758 B1 wird ein Mechanismus vorgeschlagen, mit dem Linsen mit einer Antireflexbeschichtung homogen beschichtet werden können. Dabei werden die Substrate auf einem rotierenden Teller angebracht und können um die eigene Achse gedreht werden. Eine zusätzliche Uniformitätsmaske wird dabei eingesetzt.

Der Einsatz einer schnellen Rotation hat im Wesentlichen folgende Nachteile:

- Die schnell drehende Teile können Abrieb und damit vermehrt Partikel erzeugen.

- Bei schweren optischen Komponenten sind die Kräfte sehr groß, so dass beispielsweise bei verkitteten Komponenten diese auseinander fallen können.

- Die Rotation ist zufällig, da die Drehtellerrotation selbst schon groß ist, so dass es zu Schwebungen in der Schichtverteilung kommen kann.

- Eine schnelle Rotation kann nur bei rotationssymmetrischen Komponenten eine symmetrische Schichtfunktion liefern, nicht aber bei Freiformflächen, die keine Rotationssymmetrie aufweisen.

Ausgehend hiervon war es Aufgabe der vorliegenden Erfindung eine Vorrichtung und ein Verfahren bereitzustellen, mit denen optische Komponenten mit geformten Oberflächen, z.B. Linsen, Asphären oder Freiformflächen, mit einem einstellbaren Schichtdickenprofil beschichtet werden können, wobei die genannten Nachteile der aus dem Stand der Technik bekannten Verfahren vermieden werden sollen.

Diese Aufgabe wird mit der Vorrichtung mit den Merkmalen des Anspruchs 1 und dem Verfahren mit den Merkmalen des Anspruchs 10 gelöst. Die weiteren abhängigen Ansprüche zeigen vorteilhafte Weiterbildungen auf.

Erfindungsgemäß wird eine Vorrichtung zur Beschichtung von Substraten mit planaren oder geformten Oberflächen mittels Magnetron-Sputtern bereitgestellt, die folgenden Komponenten enthält:

a) eine Vakuumkammer,

b) mindestens eine Magnetronquelle mit mindestens einer Magnetron-Elektrode als Beschichtungsquelle,

c) einen Drehteller mit mindestens einer Substrathalterung, wobei der Drehteller eine erste rotatorische Bewegung des Substrats und die mindestens eine Substrathalterung eine zweite rotatorische Bewegung ermöglicht sowie

d) mindestens ein mit der oder den Substrathalterungen gekoppelter steuerbarer Motor, der die zweite rotatorische Bewegung des Substrats bewirkt.

Erfindungsgemäß wird vorgeschlagen, dass die Drehung der Linse mittels einem steuerbaren Motor angepasst an das Schichtsystem erfolgt. Dabei soll die Drehung so erfolgen, dass die Linse vorzugsweise in dem Zeitraum, in dem sie sich nicht unter einer der Quelle befindet, um einen definierten Winkel verdreht wird. Hierbei kann ein vakuum-geeigneter steuerbarer Motor zum Einsatz kommen, der sich auf einer Substrathalterung befindet und an dessen Achse sich die optische Komponente befindet. Als steuerbarer Motor wird bevorzugt ein Schrittmotor oder ein DC-Motor verwendet. Möglich ist aber auch ein analog gesteuerter Elektromotor, der über eine Positionserkennung verfügt.

Die zyklische und langsame Rotation hat den Vorteil, dass nur wenig Strom verbraucht wird. Daher ist es bevorzugt, dass die Stromversorgung mit Hilfe einer geeigneten Batterie direkt auf der Substrathalterung vorgenommen wird, wodurch elektrische Drehdurchführungen vermieden werden können.

Gemäß einer bevorzugten Ausführungsform weist die Vorrichtung eine Gradientenblende auf, die eine inhomogene Abtragerate des Quellmaterials bewirkt. Diese Gradientenblende bzw. Shapermaske wird so ausgeführt, dass sowohl ein homogener Bereich für das Monitoring als auch ein Bereich mit einem Gradienten entsteht. Die Form der Gradientenblende kann mit Hilfe einer Simulation des Beschichtungsprozesses und einem Optimierungsalgorithmus bestimmt werden, sie kann aber auch durch manuelles Bearbeiten iterativ hergestellt werden.

Die Gradientenblende ragt für konvex geformte Substrate vorzugsweise im Bereich der Laufrichtung des Zentrums der Linse am weitesten in den Beschichtungsbereich hinein und besitzt von dort aus eine sich öffnende Form, so dass sich eine abgerundete Spitze ergibt. Im zweiten Bereich weist die Gradientenblende eine Geometrie auf, die eine homogene Beschichtung des Referenzsubstrats bewirkt.

Die Gradientenblende für konkav geformte Linsen weist vorzugsweise eine Geometrie auf, die im Bereich der Laufrichtung des Zentrums der Linse am weitesten aus dem Beschichtungsbereich herausgenommen ist und von dort aus eine in den Beschichtungsbereich hineinragende Form besitzt, so dass sich eine inverse Form einer abgerundeten Spitze ergibt. Im zweiten Bereich weist die Gradientenblende eine Geometrie auf, die eine homogene Beschichtung des Referenzsubstrats bewirkt.

Eine weitere bevorzugte Ausführungsform sieht vor, dass die Beschichtungsquelle eine inhomogene Plasmadichte aufweist, die eine inhomogene Abtragerate des Quellmaterials bewirkt. Diese Beschichtungsquelle mit inhomogener Plasmadichte kann dazu beitragen, bestimmte Ratenprofile entlang der Targetachse zu erzeugen. Mit einer weiteren Gradientenblende können diese Ratenprofile zusätzlich verstärkt werden.

Vorzugsweise ist der Schrittmotor an der Substrathalterung reversibel oder irreversibel fixiert.

Der Schrittmotor kann vorzugsweise mit einem Untersetzungsgetriebe kombiniert werden, um die Rotation des Substrats um die z-Achse feiner aufzulösen.

Alternativ besteht auch die Möglichkeit, dass das Substrat durch einen extern angeschlossenen Motor gedreht wird. Die Verbindung zwischen Motor und Substrathalterung kann mit einer vakuumtauglichen Welle vorgenommen werden. Hierbei muss auch eine Hubvorrichtung vorgesehen werden, indem die Substrathalterung aus dem Drehteller angehoben, dann gedreht und dann wieder abgesenkt wird. Hierbei muss der Drehteller jeweils angehalten werden. Hierbei kann es notwendig sein, dass bei einer Einzelschicht ein oder mehrere Zwischenhalte des Drehtellers notwendig sind. Günstig sind hierbei 3 Zwischenhalte, so dass die Komponente in drei verschiedenen Positionen beschichtet wird. Der Vorgang besteht also aus den folgenden Schritten:

- Pausieren der Beschichtung durch Schließen eines Shutters
- Anhalten des Drehtellers
- Positionierung über die Hub-Dreh-Vorrichtung
- Anheben der Substrathalterung
- Drehung der Substrathalterung um einen definierten Winkel
- Absenken der Substrathalterung
- Starten des Drehtellers
- Fortführung der Beschichtung durch Öffnen des Shutters.

Es empfiehlt sich hierbei, das optische Monitoring auf einem separaten Teller durchzuführen, der nicht gedreht wird.

Neben einer Drehung um die eigene Achse der Komponente ist grundsätzlich auch eine zusätzliche Kippung der Komponente um einen definierten Winkel möglich. Vorteilhafterweise ergibt sich damit ein weiterer Freiheitsgrad, mit dem die Verteilung der Beschichtung auf der Komponente gesteuert werden kann.

Als Beschichtungsquelle enthält die Vorrichtung eine lineare oder ringförmige Magnetronquelle. Diese kann als Einzel- oder Doppel- Magnetronquelle ausgeführt sein.

Als Substrate können sämtliche Materialien eingesetzt werden, die aus dem Stand der Technik bekanntermaßen für den Einsatz in optischen Komponenten geeignet sind. Vorzugsweise besteht das Substrat aus einem Glas oder einem Kunststoff. Als Gläser sind Quarz, Borosilikatglas, Schwefelhexafluorid (SF6) oder Kombinationen hiervon bevorzugt. Bevorzugte Kunststoffe sind Polyallyldiglycolcarbonat (PADC bzw. CR39), Polycarbonat, PMMA oder Kombinationen hiervon.

Vorzugsweise ist das Substrat eine optische Komponente, insbesondere ausgewählt aus der Gruppe bestehend aus Linsen, Asphären oder Freiform-Optiken.

Erfindungsgemäß wird ebenso ein Verfahren zur Beschichtung von Substraten mit planaren oder geformten Oberflächen mittels Magnetron-Sputtern bereitgestellt, bei dem

a) in einer Vakuumkammer mindestens ein Substrat in einer zugehörigen Substrathalterung auf einem Drehteller angeordnet wird, wobei der Drehteller eine erste rotatorische Bewegung des Substrats und die mindestens eine Substrathalterung eine zweite rotatorische Bewegung ermöglicht, wobei die zweite rotatorische Bewegung über einen mit der Substrathalterung gekoppelten steuerbaren Motor erfolgt,

b) in einem Beschichtungszyklus mit mindestens einer aus einer mindestens einer Magnetronquelle bestehenden Beschichtungsquelle mindestens eine Schicht auf dem mindestens einen Substrat abgeschieden wird, wobei die Schichten aus Quellmaterial der Magnetron-Elektroden mit Sputtergas und ggf. zusätzliche Zugabe von Reaktivgas gebildet werden,

c) die erste rotatorische Bewegung mit der zweiten rotatorischen Bewegung so abgestimmt wird, dass die zweite rotatorische Bewegung nur außerhalb des Beschichtungszyklus erfolgt.

Vorzugsweise wird im Schritt b) eine Gradientenblende zur Abscheidung von Schichten verwendet, die einen Gradienten hinsichtlich der Schichtdicken erzeugen, wobei die Gradientenblende vorzugsweise einen ersten Bereich zur inhomogenen Beschichtung des Substrats aufweist, bei der für konvex geformte Substrate im Bereich der Laufrichtung des Zentrums der Linse am weitesten in den Beschichtungsbereich hineinragt und von dort aus eine sich öffnende Form besitzt, so dass sich eine abgerundete Spitze ergibt. Im zweiten Bereich weist die Gradientenblende eine Geometrie auf, die eine homogene Beschichtung eines Referenzsubstrats bewirkt.

Eine weiter bevorzugte Ausführungsform sieht vor, dass im Schritt b) eine Gradientenblende zur Abscheidung von Schichten verwendet wird, die einen Gradienten hinsichtlich der Schichtdicken erzeugen, wobei die Gradientenblende vorzugsweise einen ersten Bereich, der eine Geometrie zur inhomogenen Beschichtung des Substrats aufweist, indem für konkav geformte Linsen im Bereich der Laufrichtung des Zentrums der Linse am weitesten aus dem Beschichtungsbereich herausgenommen ist und von dort aus eine in den Beschichtungsbereich hineinragende Form besitzt, so dass sich eine inverse Form einer abgerundeten Spitze ergibt und einen zweiten Bereich mit einer Geometrie, die eine homogene Beschichtung eines Referenzsubstrats bewirkt.

Es ist bevorzugt, dass die Form der Gradientenblende über die lokale Verteilung der Beschichtungsrate erfasst wird, wobei die Beschichtungsrate über die Form der Linse in Abhängigkeit von der Blendenform ermittelt wird.

Die erste rotatorische Bewegung des Drehtellers erfolgt dabei vorzugsweise mit einer Geschwindigkeit von 10 bis 300 rpm, bevorzugt 50 bis 270 rpm und besonders bevorzugt 70 bis 250 rpm. So wird bei jedem Durchlauf eine Schichtdicke von bevorzugt 0,01nm bis 0,54nm und besonders bevorzugt 0,05 bis 0,18 nm erreicht, wodurch eine Beschichtungsrate von 0,1nm/sec bis 1nm/sec erreicht werden kann.

Die abgeschiedene Gesamt-Schichtdicke liegt im Bereich von 1 bis 1000 nm, bevorzugt 3 bis 500 nm. Die jeweilige Schichtdicke orientiert sich hierbei am jeweiligen Schichtdesign, welches Schichtdicken von wenigen nm bis mehreren 100nm pro Einzelschicht haben kann.

Es ist bevorzugt, dass für jede abgeschiedene Schicht eine kontinuierliche erste rotatorische Bewegung mit einer Geschwindigkeit von 10 bis 300 rpm, bevorzugt 50 bis 270 rpm und eine schrittweisezweite rotatorische Bewegung mit n Schritten und einer Bewegung um einen Winkel von 360°/n, wobei n = 3, 6, 9, etc. erfolgt.

Die Rotation erfolgt vorzugsweise in vordefinierten Schritten und wird durch eine Software gesteuert. Die Schrittweite wird vorzugsweise so berechnet, dass bei jeder Winkelstellung ein bestimmtes Schichtprofil erzeugt wird. Die Anzahl der notwendigen Schritte wird im Vorfeld durch die Software berechnet.

Während bei Linsen und Asphären eine Rotationssymmetrie um den Mittelpunkt der Komponente vorliegt, ist diese bei Freiformflächen im allgemeinen nicht mehr gegeben. Daher wird für Freiformflächen vorzugsweise die Schrittsteuerung angepasst, so dass ein für einen bestimmten Bereich der Freiformoptik angepasstes Schichtdickenprofil erzielt wird.

Das erfindungsgemäße Verfahren und die erfindungsgemäße Vorrichtung können auch dazu genutzt werden, um bestimmte Gradienten auf planaren Oberflächen abzuscheiden, wodurch Gradientenfilter hergestellt werden können. Dieses ist vorteilhaft, weil der Gradient der Gradientenfilter nicht gerade ist, sondern eine Kreisbahn beschreibt. Ebenso kann eine zusätzliche Homogenisierung der Schichtdickenverteilung auf planaren Substraten vorgenommen werden.

Auch kann das erfindungsgemäße Verfahren dazu benutzt werden, um Gradienten mit unterschiedlicher Steigung zu verwenden. Somit können beispielsweise auch Stufenprofile erzeugt werden. Dies ist hilfreich, wenn beispielsweise mehrere kleinere Objekte zu beschichten sind, die jeweils eine homogene Beschichtung erhalten sollen, aber bei denen sich die Schichtdicke jeweils unterscheidet.

Auch können mit dem erfindungsgemäßen Verfahren unterschiedliche Gradienten auf einer Komponente aufgebracht werden. Das ist nützlich, wenn z.B. eine Linse mehrmals von einem Strahlenbündel durchlaufen wird, wobei sich der Öffnungswinkel und/oder der Einfallswinkel unterscheidet.

Anhand der nachfolgenden Figuren und Beispiele soll der erfindungsgemäße Gegenstand näher erläutert werden, ohne diesen auf die hier gezeigten spezifischen Ausführungsformen einschränken zu wollen.

Fig. 1 zeigt eine Vorrichtung ohne Drehteller in der Draufsicht

Fig. 2 zeigt eine Vorrichtung mit Drehteller in der Draufsicht

Fig. 3 zeigt eine Vorrichtung mit Drehteller in einer Schnittdarstellung

Fig. 4 zeigt eine erste erfindungsgemäße Substrathalterung in einer Schnittdarstellung

Fig. 5 zeigt eine zweite erfindungsgemäße Substrathalterung in einer Schnittdarstellung

Fig. 6 zeigt eine erste erfindungsgemäße Substrathalterung in einer Schnittdarstellung

Fig. 7 zeigt die erfindungsgemäße Beschichtung einer Linse anhand einer schematischen Darstellung

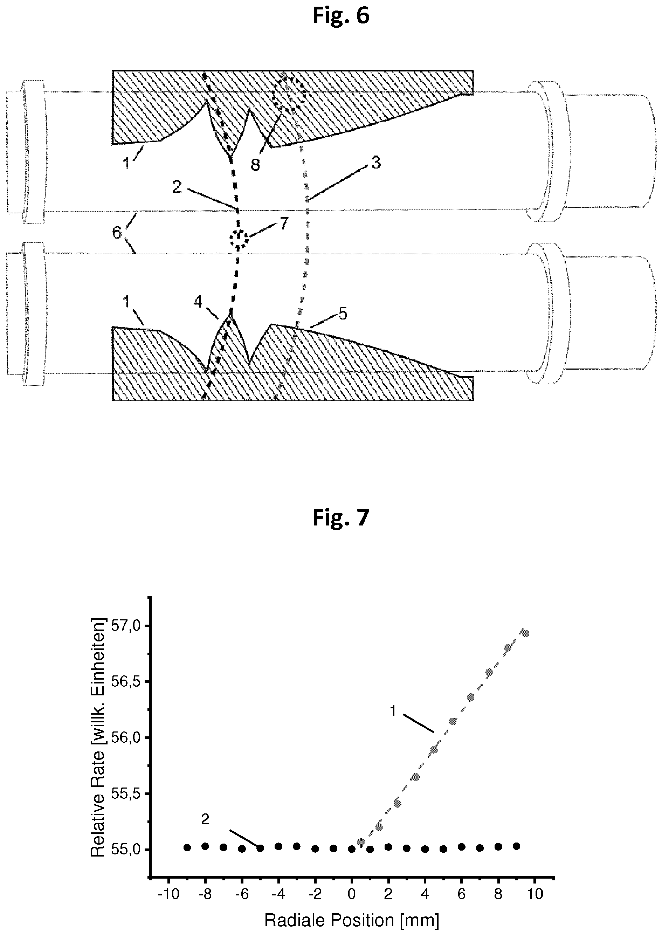

Fig. 7 zeigt anhand eines Diagramms die Beschichtungsrate in Abhängigkeit von der radialen Position der Linse

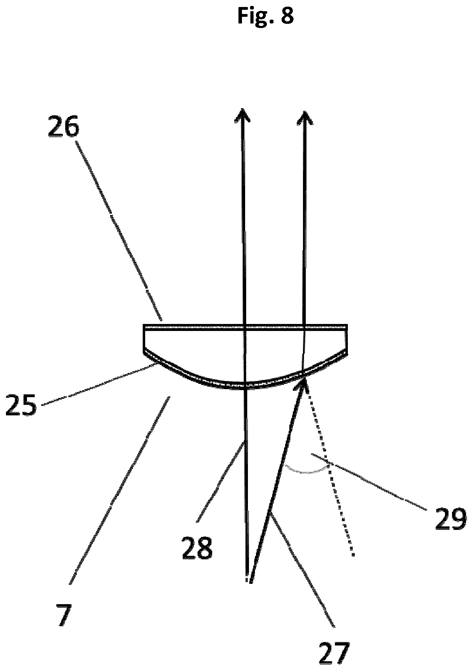

Fig. 8 zeigt eine erfindungsgemäß beschichtete Linse

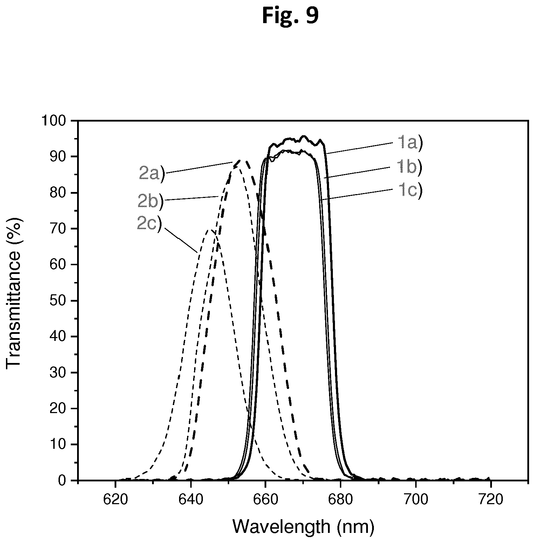

Fig. 9 zeigt ein Spektrum einer erfindungsgemäß beschichteten Linse

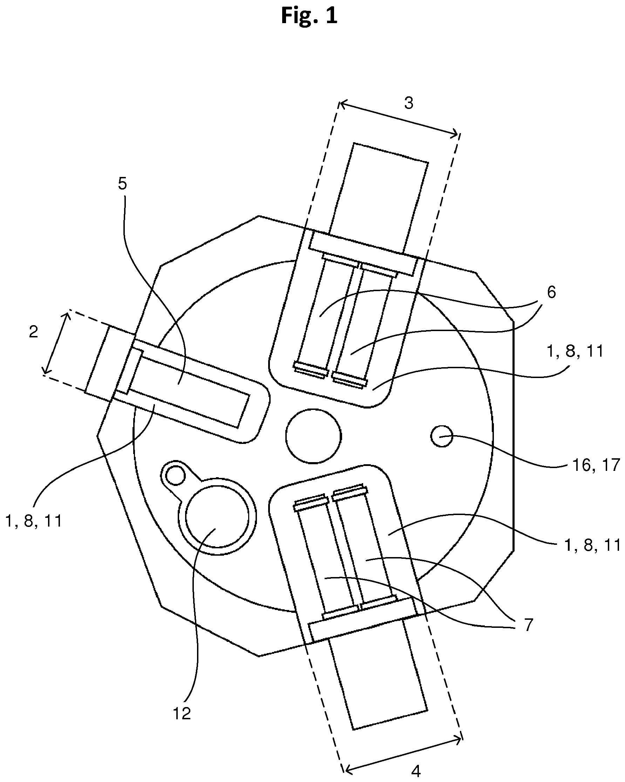

Fig. 1 zeigt schematisch in der Draufsicht eine bevorzugte erfindungsgemäße Vorrichtung ohne Drehteller. Die Vorrichtung weist drei Magnetron-Sputtereinrichtungen 2, 3, 4 auf, wovon eine in der Einzelmagnetronanordung 2 und zwei in der Doppelmagnetronanordnung 3, 4 ausgestaltet sind. Die Magnetron-Sputtereinrichtungen 2 enthält eine Magnetron-Elektrode 5, Sputtergas 11, optional Reaktivgas 8 und befindet sich im Vakuum 1. Die Magnetron-Sputtereinrichtungen 3, 4 enthalten jeweils zwei Magnetron-Elektroden 6, 7, Sputtergas 11, optional Reaktivgas 8 und befinden sich im Vakuum 1. In der Nachbarschaft der Magnetron-Sputtereinrichtungen 2, 3, 4 befindet sich eine Plasmaquelle 12 und ein Photometer 16 und/oder eine Ellipsometrieflansche 17.

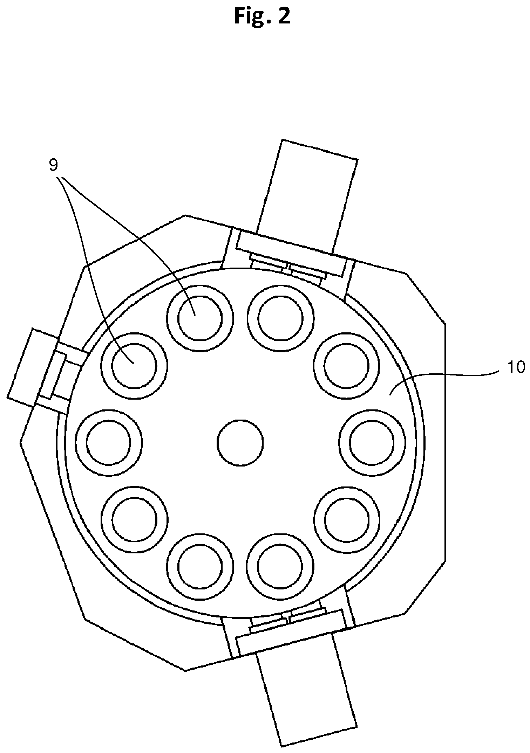

Fig. 2 zeigt schematisch in der Draufsicht eine bevorzugte Ausgestaltung des Drehtellers. Der Drehteller 10 befindet sich in der Vorrichtung und weist in diesem Beispiel zehn identische Substrathalterungen 9 auf.

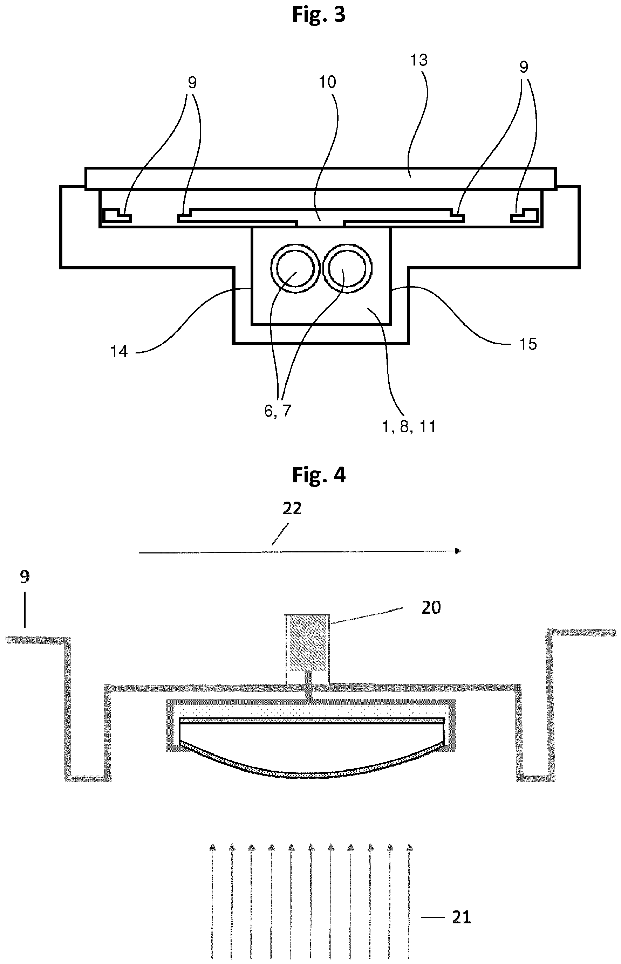

Fig. 3 zeigt schematisch in der Seitenansicht eine bevorzugte Ausgestaltungsform der Vorrichtung mit Drehteller 10. Es ist der Querschnitt einer Magnetron-Sputtereinrichtung sichtbar, welche zwei Zylinder aus Quellmaterial 6, 7 enthält (Doppelmagnetronanordnung). Die Magnetron-Sputtereinrichtung ist an den Seiten von Begrenzungswänden 14, 15 und oben durch den Drehteller 10 gasdicht vom Rest der Vorrichtung abgegrenzt, enthält Sputtergas 11, optional Reaktivgas 8, und ist unter Vakuum 1. Zwei Substrathalterungen 9 des Drehtellers 10 sind in dem Querschnitt dargestellt bzw. sichtbar. Oberhalb des Drehtellers 10 befindet sich ein Deckel 13, welcher mit Begrenzungswänden, welche sich seitlich des Drehtellers 10 befinden, die Vorrichtung gasdicht abschließt.

Fig. 4 zeigt den Aufbau einer erfindungsgemäßen Substrathalterung 9. Hierbei ist eine Linse 18 rotierend mit der Achse eines Motors 20 gekoppelt. Der Motor 20 ist auf der Substrathalterung 9 fest montiert und kann von außen gesteuert werden. Ein Monitorbereich ist hierbei nicht vorgesehen. Die Beschichtungsrichtung 21 erfolgt von unten nach oben und die Bewegung 22 der Substrathalterung von links nach rechts.

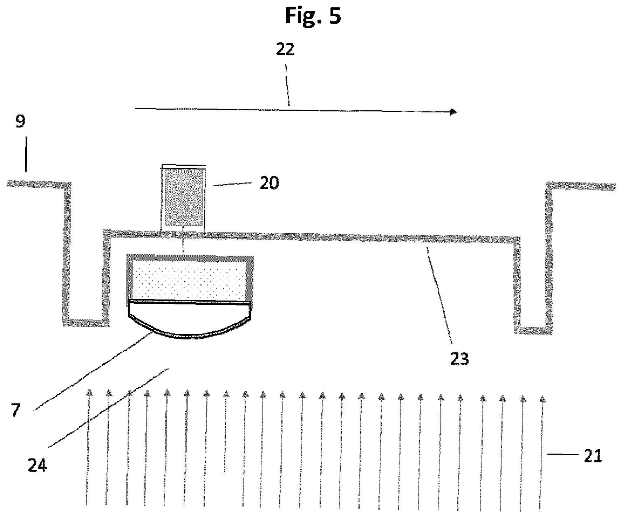

Fig. 5 zeigt einen Aufbau einer zu beschichtenden Linse 18 in einer weiteren erfindungsgemäßen Substrathalterung 9. Die Linse 18 befindet sich in einem Bereich 24, wo die Beschichtungsrate einen lateralen Gradienten aufweist, während für die Referenzmessung ein Beschichtungsbereich 23 ohne Gradient vorgesehen ist. Das dafür vorgesehene Monitorglas kann auf der gezeigten Substrathalterung 9 mitlaufen oder sich auf einer der anderen Substrathalterungen 9 befinden.

Fig. 6 zeigt die erfindungsgemäße Anordnung mit dem Doppelmagnetron 6, der Linse 18 und dem Referenzglas 19. Die Maske 21 ist so geformt, dass sie auf einem ebenen Substrat einen homogenen Beschichtungsbereich ermöglicht sowie einen Bereich mit einem lateralen Schichtdickengradienten. Der homogene Bereich liegt auf der Kreisbahn 23 und wird durch die Spitze 24 realisiert; der inhomogene Bereich auf der Kreisbahn 22 und wird durch die flachere Form 25 erreicht.

Fig. 7 stellt die relative Beschichtungsrate auf dem flachen Referenzglas 19 bzw. auf der rotierenden Linse 18 dar. Auf der Linse 9 ergibt sich eine ansteigende Rate vom Zentrum nach außen hin (von der x-Achse 0 bis 10mm nach rechts). Die Datenpunkte 1) in Figur 8 sind spiegelsymmetrisch zur Position 0 der x-Achse zu sehen.

Fig. 8 zeigt eine Linse 18 wie sie typisch beschichtet werden kann. Sie hat einen Durchmesser von 20mm und einen Krümmungsradius von 25.8 mm. Es ist ein senkrecht auf die Linse 18 auftreffender Lichtstrahl 28 und ein schräg auf die Linse 18 auftreffender Lichtrahl 27 dargestellt. Der Einfallswinkel 29 steigt im Brennpunkt von 0° im Zentrum auf 16° in einem Punkt von 5 mm vom Zentrum entfernt. Diese Linse wurde mit einem Bandpassfilter auf der konvexen Seite 25 beschichtet. Auf der planaren Seite 26 kann eine Beschichtung mit Breitband, Antireflex oder Blocker erfolgen.

Fig. 9 zeigt gemessene Spektren der beschichteten Linse an verschiedenen Positionen. Die Beschichtung besteht aus einem Bandpass mit einer Zentralwellenlänge von etwa 665nm. Es wurden $SiO_2$ und $Ta_2O_5$ als nieder- bzw. hochbrechende Materialien eingesetzt.

**Beispiel 1**

In einem Schichtstapel wird eine SiO2-Schicht mit einer Dicke von 100nm aufgebracht. Die dynamische Rate beträgt 0.4nm/sec bei rotierendem Teller mit Rotationsfrequenz von 240rpm, d.h. 0.1nm pro Umlauf. Für die 100nm Schicht sind dann 1000 Durchläufe notwendig. In diesem Beispiel wird nach 250, nach 500 und nach 750 Umdrehungen eine Drehung um 90° durchgeführt.

**Beispiel 2**

In einem zweiten Beispiel wird eine Drehung jeweils nach 25 Umläufen um 9° vorgenommen, um eine feinere Einteilung zu bekommen.

**Patentansprüche**

1. Vorrichtung zur Beschichtung von Substraten mit planaren oder geformten Oberflächen mittels Magnetron-Sputtern enthaltend

  a) eine Vakuumkammer,
  b) mindestens eine Magnetronquelle (2, 3, 4) mit mindestens einer Magnetron-Elektrode (5, 6, 7) als Beschichtungsquelle,
  c) einen Drehteller (10) mit mindestens einer Substrathalterung (9), wobei der Drehteller (10) eine erste rotatorische Bewegung des Substrats (18) und die mindestens eine Substrathalterung (9) eine zweite rotatorische Bewegung ermöglicht sowie
  d) mindestens ein mit der mindestens einen Substrathalterung (9) gekoppelter steuerbarer Motor (20), der die zweite rotatorische Bewegung des Substrats bewirkt.

2. Vorrichtung nach Anspruch 1,
  **dadurch gekennzeichnet, dass** die Vorrichtung eine Gradientenblende (21) aufweist mit

  • einem ersten Bereich, der eine Geometrie zur inhomogenen Beschichtung des Substrats aufweist, indem für konvex geformte Substrate im Bereich der Laufrichtung des Zentrums der Linse am weitesten in den Beschichtungsbereich hineinragt und von dort aus eine sich öffnende Form besitzt, so dass sich eine abgerundete Spitze ergibt und
  • einem zweiten Bereich mit einer Geometrie, die eine homogene Beschichtung eines Referenzsubstrats bewirkt.

3. Vorrichtung nach Anspruch 1,
  **dadurch gekennzeichnet, dass** die Vorrichtung eine Gradientenblende (21) aufweist mit

  • einem ersten Bereich, der eine Geometrie zur inhomogenen Beschichtung des Substrats aufweist, indem für konkav geformte Linsen im Bereich der Laufrichtung des Zentrums der Linse am weitesten aus dem Beschichtungsbereich herausgenommen ist und von dort aus eine in den Beschichtungsbereich hineinragende Form besitzt, so dass sich eine inverse Form einer abgerundeten Spitze ergibt und
  • einem zweiten Bereich mit einer Geometrie, die eine homogene Beschichtung eines Referenzsubstrats bewirkt.

4. Vorrichtung nach einem der vorhergehenden Ansprüche,
  **dadurch gekennzeichnet, dass** die Gradientenblende (21) mehrere Bereiche mit unterschiedlicher Geometrie aufweist, die eine Beschichtung des Substrats mit unterschiedlichen Gradienten ermöglicht.

5. Vorrichtung nach einem der vorhergehenden Ansprüche,
  **dadurch gekennzeichnet, dass** der steuerbare Motor (19), bevorzugt ein Schrittmotor, DC-Motor oder Synchronmotor mit Positionsdetektion, an der Substrathalterung reversibel oder irreversibel fixiert ist, wobei der steuerbare Motor innerhalb oder außerhalb der Vakuumkammer angeordnet sein kann.

6. Vorrichtung nach einem der vorhergehenden Ansprüche,
  **dadurch gekennzeichnet, dass** die Beschichtungsquelle eine lineare, ringförmige oder rohrförmige Magnetronquelle ist, insbesondere als Einzel- oder Doppel-Magnetronquelle.

7. Vorrichtung nach einem der vorhergehenden Ansprüche,
  **dadurch gekennzeichnet, dass** das Substrat (18) aus einem Glas, insbesondere ausgewählt aus der Gruppe bestehend aus Quarz, Borosilikatglas, Schwefelhexafluorid ($SF_6$) oder Kombinationen hiervon, oder einem Kunststoff, insbesondere ausgewählt aus der Gruppe bestehend aus Polyallyldiglycolcarbonat (PADC bzw. CR39), Polycarbonat, PMMA oder Kombinationen hiervon, besteht oder im wesentlichen enthält.

8. Vorrichtung nach einem der vorhergehenden Ansprüche,
  **dadurch gekennzeichnet, dass** das Substrat (18) eine optische Komponente ist, insbesondere ausgewählt aus der Gruppe bestehend aus Linsen, Asphären oder Freiform-Optiken, wobei die optische Komponente bevorzugt einen Durchmesser von 5 mm bis 100 mm, besonders bevorzugt 20 mm bis 200 mm aufweist.

**9.** Vorrichtung nach dem vorhergehenden Anspruch,
**dadurch gekennzeichnet, dass** die Linse plan, konvex oder konkav ist, wobei die Krümmungsradien der Linse bevorzugt im Bereich von 5 mm bis 100 m, besonders bevorzugt von 10 mm bis 1 m liegt.

**10.** Verfahren zur Beschichtung von Substraten mit planaren oder geformten Oberflächen, insbesondere ausgewählt aus der Gruppe bestehend aus Linsen, Asphären oder Freiform-Optiken, mittels Magnetron-Sputtern, bei dem

a) in einer Vakuumkammer mindestens ein Substrat (18) in einer zugehörigen Substrathalterung (9) auf einem Drehteller (10) angeordnet wird, wobei der Drehteller (10) eine erste rotatorische Bewegung des Substrats (18) und die mindestens eine Substrathalterung (9) eine zweite rotatorische Bewegung ermöglicht, wobei die zweite rotatorische Bewegung über einen mit der Substrathalterung (9) gekoppelten steuerbaren Motor (20) erfolgt,
b) in einem Beschichtungszyklus mit mindestens einer Magnetronquelle (2, 3, 4) mit mindestens einer Magnetron-Elektrode (5, 6, 7) mindestens eine Schicht auf dem mindestens einen Substrat (18) abgeschieden wird, wobei die Schichten aus Quellmaterial der Magnetron-Elektroden mit Sputtergas und ggf. Reaktivgas gebildet werden,
c) die erste rotatorische Bewegung mit der zweiten rotatorischen Bewegung so abgestimmt wird, dass die zweite rotatorische Bewegung nur außerhalb des Beschichtungszyklus erfolgt.

**11.** Verfahren nach Anspruch 10,
**dadurch gekennzeichnet, dass** die erste rotatorische Bewegung mit einer Geschwindigkeit von 30 bis 300 rpm, bevorzugt von 50 bis 270 rpm und besonders bevorzugt von 70 bis 250 rpm erfolgt.

**12.** Verfahren nach einem der Ansprüche 10 oder 11,
**dadurch gekennzeichnet, dass** die abgeschiedene Schichtdicke pro Schicht im Bereich von 1 bis 1000 nm, bevorzugt 3 bis 500 nm und die Zahl der Schichten bevorzugt im Bereich von 1 bis 1000, besonders bevorzugt von 4 bis 100 liegt liegt.

**13.** Verfahren nach einem der Ansprüche 10 bis 12,
**dadurch gekennzeichnet, dass** für jede abgeschiedene Schicht eine kontinuierliche erste rotatorische Bewegung mit einer Geschwindigkeit von 10 bis 300 rpm, bevorzugt 50 bis 270 rpm und besonders bevorzugt 70 bis 250 rpm und eine schrittweisezweite rotatorische Bewegung mit n Schritten und einer Bewegung um einen Winkel von 360°/n, wobei n = 3, 6, 9, 12 erfolgt.

**14.** Verfahren nach einem der Ansprüche 10 bis 13,
**dadurch gekennzeichnet, dass** im Schritt b) eine Gradientenblende (21) zur Abscheidung von Schichten verwendet wird, die einen Gradienten hinsichtlich der Schichtdicken erzeugen, wobei die Gradientenblende (21) vorzugsweise

• einen ersten Bereich, der eine Geometrie zur inhomogenen Beschichtung des Substrats aufweist, indem für konvex geformte Substrate im Bereich der Laufrichtung des Zentrums der Linse am weitesten in den Beschichtungsbereich hineinragt und von dort aus eine sich öffnende Form besitzt, so dass sich eine abgerundete Spitze ergibt und
• einen zweiten Bereich aufweist mit einer Geometrie, die eine homogene Beschichtung eines Referenzsubstrats bewirkt.

**15.** Verfahren nach einem der Ansprüche 10 bis 14,
**dadurch gekennzeichnet, dass** im Schritt b) eine Gradientenblende (21) zur Abscheidung von Schichten verwendet wird, die einen Gradienten hinsichtlich der Schichtdicken erzeugen, wobei die Gradientenblende (21) vorzugsweise

• einen ersten Bereich, der eine Geometrie zur inhomogenen Beschichtung des Substrats aufweist, indem für konkav geformte Linsen im Bereich der Laufrichtung des Zentrums der Linse am weitesten aus dem Beschichtungsbereich herausgenommen ist und von dort aus eine in den Beschichtungsbereich hineinragende Form besitzt, so dass sich eine inverse Form einer abgerundeten Spitze ergibt und
• einen zweiten Bereich aufweist mit einer Geometrie, die eine homogene Beschichtung eines Referenzsubstrats bewirkt.

**16.** Verfahren nach einem der Ansprüche 10 bis 15,
**dadurch gekennzeichnet, dass** die Form der Gradientenblende (21) über die lokale Verteilung der Beschichtungsrate erfasst wird, wobei die Beschichtungsrate über die Form der Linse in Abhängigkeit von der Blendenform ermittelt wird.

**17.** Verfahren nach einem der Ansprüche 10 bis 16, bei dem eine Vorrichtung nach einem der Ansprüche 1 bis 9 eingesetzt wird.

**Fig. 1**

# Fig. 2

## Fig. 3

## Fig. 4

# Fig. 5

## Fig. 6

## Fig. 7

**Fig. 8**

**Fig. 9**

**Europäisches Patentamt**
**European Patent Office**
**Office européen des brevets**

# EUROPÄISCHER RECHERCHENBERICHT

Nummer der Anmeldung

EP 19 16 8047

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2017 104858 A1 (SCIA SYSTEMS GMBH [DE]) 13. September 2018 (2018-09-13) | 1,5-13, 17 | INV. C23C14/04 C23C14/50 C23C14/54 |
| Y | * Absätze [0024], [0049], [0052], [0068], [0069], [0110], [0111]; Abbildung 8 * ----- | 2-4, 14-16 | |
| Y | DE 103 08 471 A1 (HENSOLDT & SOEHNE OPTIK [DE]) 16. September 2004 (2004-09-16) * Anspruch 1; Abbildungen 1,4,5 * ----- | 2-4, 14-16 | |
| Y,D | US 6 250 758 B1 (YOSHIHARA MASAAKI [JP] ET AL) 26. Juni 2001 (2001-06-26) * Spalte 15, Zeile 47 - Spalte 17, Zeile 27; Abbildungen 8-10 * ----- | 2-4, 14-16 | |
| A | US 2014/262752 A1 (VERGÖHL MICHAEL [DE] ET AL) 18. September 2014 (2014-09-18) * Absatz [0034] * ----- | 11 | |

**RECHERCHIERTE SACHGEBIETE (IPC)**

C23C

Der vorliegende Recherchenbericht wurde für alle Patentansprüche erstellt

| Recherchenort | Abschlußdatum der Recherche | Prüfer |
|---|---|---|
| Den Haag | 14. Oktober 2019 | Schuhmacher, Jörg |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 19 16 8047

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-10-2019

| Im Recherchenbericht angeführtes Patentdokument | Datum der Veröffentlichung | Mitglied(er) der Patentfamilie | Datum der Veröffentlichung |
|---|---|---|---|
| DE 102017104858 A1 | 13-09-2018 | KEINE | |
| DE 10308471 A1 | 16-09-2004 | KEINE | |
| US 6250758 B1 | 26-06-2001 | AU 741691 B2<br>CN 1226970 A<br>CN 1480744 A<br>EP 0928977 A1<br>KR 20000023795 A<br>US 6250758 B1<br>WO 9852074 A1 | 06-12-2001<br>25-08-1999<br>10-03-2004<br>14-07-1999<br>25-04-2000<br>26-06-2001<br>19-11-1998 |
| US 2014262752 A1 | 18-09-2014 | CA 2842253 A1<br>DK 2735018 T3<br>EP 2549521 A1<br>EP 2735018 A1<br>JP 2014520966 A<br>JP 2017226920 A<br>JP 2019131891 A<br>US 2014262752 A1<br>WO 2013011149 A1 | 24-01-2013<br>16-01-2017<br>23-01-2013<br>28-05-2014<br>25-08-2014<br>28-12-2017<br>08-08-2019<br>18-09-2014<br>24-01-2013 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6250758 B1